# EUROPEAN PATENT SPECIFICATION

(11) **EP 0 190 767 B1**
(45) Date of publication and mention of the grant of the patent: **14.05.1997**
(21) Application number: 86101613.7
(22) Date of filing: 07.02.1986
(51) Int. Cl.: H01L 39/14

(54) **Superconductor for a magnetic field shielding and a process for making such superconductors**
Supraleiter für Magnetfeldabschirmung und Verfahren zu dessen Herstellung
Supraconducteur pour blindage contre champs magnétiques et son procédé de sa fabrication

(30) Priority: 08.02.1985 JP 24254/85
(43) Date of publication of application: 13.08.1986
(73) Proprietor: Saji, Yoshiro, Suita-shi Osaka (JP); Koatsu Gas Kogyo Co., Ltd., Osaka-shi (JP)
(72) Inventor: Saji, Yoshiro, Suita-shi Osaka (JP); Tada, Eiichi, Nada-ku Kobe-shi (JP); Toda, Hiroaki, Shiki-gun Nara-ken (JP); Kawahara, Yoshiaki, Himeji-shi Hyogo-ken (JP)
(74) Representative: Sajda, Wolf E., Dipl.-Phys.

(56) References cited:
- CH-A- 458 462
- NUCLEAR INSTRUMENTS AND METHODS, vol. 103, 1972, pages 503-514, North-Holland Publishing Co., Amsterdam, NL; F. MARTIN et al.: "A four-meter long superconducting magnetic flux exclusion tube for particle physics experiments"

## Description

The present invention relates to a magnetic field shield, including a plurality of composite laminations of a metal layer which efficiently radiates or dissipates heat, and a superconductor film made of a type II superconductor. The invention also relates to a process for producing a magnetic field shield.

As a magnetic field shield using superconductivity, two types of material are used, namely first class superconductors as type I, and second class superconductors as type II, depending on the intensity of a respective magnetic field. A superconductor for a magnetic field shield belonging to the first class superconductors uses perfect diamagnetism (Meißner effect), as a property of superconductivity. Such a superconductor cannot shield intense magnetic fields since its critical magnetic flux density is low. A superconductor for a magnetic field shield belonging to the second class superconductors utilizes a mixture of a superconductivity state and a normal conductivity state, and its critical magnetic field comprises an upper and a lower critical magnetic flux density. Since the upper critical magnetic flux density is extremely high, a superconductor belonging to the second class superconductors can be used to shield intense magnetic fields. When such a superconductor has a greater thickness its shielding effect increases. Therefore, thick superconductors are used for shielding intense magnetic fields. However, due to a local flux flow such a thick superconductor may generate heat, resulting in a reduced shielding effect (secondary harmful effect). Accordingly, when a second class superconductor as mentioned above is used to shield intense magnetic fields, conventionally relatively thick sheets or tapes of the superconductor are laminated in many layers or alternately laminated with aluminum or copper sheets. Since these two laminated types are thick and have a considerable weight when they are made for shielding intense magnetic fields, they are not satisfactory in practical use.

Furthermore, the former laminated type has a low stability since it easily causes flux jumping due to quick excitation even in weak magnetic fields. Namely, magnetic fluxes enter and move into the central section of the superconductor increasing the temperature of the superconductor and causing a phenomenon of a catastrophic effect due to the entry of more fluxes . The latter laminated type has a better construction than the former one, since aluminum or copper sheets are effective in cooling. Nevertheless, the characteristics of the superconductor are not fully delivered even when the construction of the latter type is used. Moreover, since it was believed that a higher shielding effect could be obtained from a thicker superconductor and as the thickness of the superconductor was assumed to be simply proportional to the magnetic field shielding effect, a thick superconductor was thought to be more advantageous than laminated thin superconductor layers in reducing production cost and production processes provided that means were taken for preventing the above-mentioned heat generation.

A magnetic field shield of the type specified above is known from the publication Nuclear Instruments and Methods, Vol. 103, 1972, pages 503 to 514, North Holland Publishing Co.; F. Martin et al., "A four meter long superconducting magnet flux exclusion tube for particle physics experiments". In one of the conventional embodiments, an Nb-Ti foil is used in a thickness range from 300 µm down to 33 µm, with and without interleaved copper spacers. The construction involved winding 30 cm wide material around a stainless steel mandrel into a multilayer spiral. In another conventional embodiment described in that document, a material is used which consists of a niobium substrate having a thickness of 6 to 12 µm and carrying on both sides an Nb₃Sn layer having a thickness of 2 to 3 µm which in turn is protected by a layer of electrolytic copper, wherein the whole sandwich has a thickness of about 30 to 35 µm. Such a sandwich tape is wound spirally under constant tension on stainless steel mandrels for shielding purposes. Also, it is explained in that document that the 30 µm thick tape proved rather difficult to work with so that they switched to 120 µm material which is a composite sandwich of two niobium tapes and four Nb₃Sn layers between two copper cladding layers, each 30 µm thick.

The document CH-A-458 462 relates to a superconductor material per se, which comprises several layers of a first material, which shows superconducting electric properties at low absolute temperatures, and, for the purpose of forming a composed material with alternating layer structure, also comprises layers of a second material each of which is disposed between respective pairs of these layers of the first material and which second material does not have superconducting electric properties at the said low absolute temperature. The properties and features of a magnetic shield are not discussed in that document.

The object underlying the present invention is to provide a magnetic field shield and a process for producing such a magnetic field shield using a type II superconductor in order to achieve a magnetic field shield which has an outstanding magnetic field shielding effect without being affected in operation by heat generation.

In a first embodiment of the present invention, the magnetic field shield of the type specified above is characterized in that the thickness of each superconductor film is in the range of 2 to 20 µm, in that the thickness of each superconductor film is determined from the point of inflexion of a graph representing the relationship between the magnetic shielding effect and the thickness of a single superconductor film, and in that the thickness of each superconductor film is not more than that obtained at the point of inflexion of the graph.

In a second embodiment of the present invention, the magnetic field shield of the type specified above is characterized in that the type II superconductor material is Nb-Ti, in that the thickness of each superconductor film is in the range of 0.95 to 20 µm, in that the thickness of each superconductor film is determined from the point of inflexion of a graph representing the relationship between the magnetic shielding effect and the thickness of a single superconductor film, and in that the thickness of each superconductor film is not more than that obtained at the point of inflexion of the graph, which is 20 µm in the case of Nb-Ti.

According to a further development of the first embodiment of the present invention, the superconductor material is selected from the group of niobium, niobium alloys, niobium compounds or vanadium compounds, in particular Nb, Nb-Zr, NbN·TiN, NbN, NbC, Nb₃Sn, Nb₃Al, Nb₃Ga, Nb₃Ge and/or V₃Ga.

In a further development of the first embodiment, the superconductor film is made of an NbN·TiN compound and the metal layer is made of high-purity aluminum or copper.

In a further development of the shield according to the second embodiment, the superconductor film is made of an Nb-Ti alloy and the metal layer is made of high-purity aluminum or copper.

According to a further development of the magnetic field shield according to the invention, the superconductor film is formed on the metal layer by thin-film forming techniques such as sputtering.

In another further development of the magnetic field shield according to the invention, the superconductor film is closely contacted with the metal layer by ultrasonic soldering or is laminated with the metal layer without adhering means.

In a further development of the magnetic field shield according to the invention, the metal layer is a sheet metal made of aluminum or copper, in particular a thin aluminum film or a thin copper film made by thin-film forming techniques.

In a still further development of the magnetic field shield according to the invention, the plurality of the composite laminations consists of thin superconductor layers which are alternately laminated on a metal sheet and further metal films, respectively.

According to a still further development of the magnetic field shield according to the invention, the thickness of each superconductor film is in the range of 2 to 10 µm.

A first embodiment of the process for producing a magnetic field shield according to the invention comprises the following steps:
determining the point of inflexion on a graph of the relationship between the magnetic shielding effect and the thickness of a single superconductor film of a type II superconductor material;
selecting a thickness of the superconductor film in the range of 2 to 20 µm, wherein the thickness is no more than the thickness value at the point of inflexion; and
forming a plurality of composite laminations, each comprising the superconductor layer formed on a metal layer.

A second embodiment of the process for producing a magnetic field shield according to the invention comprises the following steps:
determining the point of inflexion on a graph of the relationship between the magnetic shielding effect and the thickness of a single superconductor film of the type II superconductor material Nb-Ti;
selecting a thickness of the superconductor film in the range of 0.95 to 20 µm, wherein the latter value is the thickness value at the point of inflexion; and
forming a plurality of composite laminations, each comprising the superconductor layer formed on a metal layer.

The present invention achieves completely new results which have been obtained after researching the basic characteristics of superconductors in an attempt to obtain light and stable magnetic field shields. The invention is based upon the finding that on a graph representing the relationship between the magnetic shielding effect and the thickness of a single superconductor film, the magnetic field shielding effect increases very steeply from the vicinity of the origin to a point of inflexion and beyond such a point of inflexion increases only gradually as the thickness of the superconductor film increases.

Furthermore, it has been found by the inventors that the magnetic field shielding effect is proportional to the number of layers of the superconductor films when a superconductor comprises a plurality of layers of the same material each of which has the same thickness. In other words, the magnetic field shielding effect of the whole superconductor is the effect of a single superconductor layer multiplied by the number of layers.

According to the present invention, based on the above effects, a magnetic field shield is provided which is very light, stable and useful when compared with conventional devices.

The invention will be explained in further details in the following description of preferred embodiments and with reference to the enclosed drawings, wherein
Fig. 1 is a graph illustrating the relationship between the thickness of a Nb-Ti alloy film and its magnetic field shielding effect;
Fig. 2 is a graph illustrating the relationship between the total thickness of Nb-Ti alloy films (lamination effect) and their magnetic field shielding effect;
Fig. 3 is a partial vertical sectional view illustrating an embodiment of a superconductor for a shield according to the present invention and having a single film layer; and
Fig. 4 is a partial vertical sectional view illustrating another embodiment of a superconductor according to the present invention and having a multilayer structure.

A superconductor for a magnetic field shield according to the present invention includes a superconductor film having a characteristic curve as to the relationship between the thickness of a single layer of the superconductor film and the magnetic field shielding effect of the superconductor film.

According to the invention, a superconductor for a magnetic field shield is characterized in that it comprises at least one layer of a composite lamination comprising a thin film of the superconductor and a metal layer (foil, sheet or film) laminated with the thin film of the superconductor having a thickness which is not larger than that obtained at the point of inflexion of a graph representing the relationship between the magnetic shielding effect and the thickness of a single superconductor film.

According to the invention, niobium, niobium alloys, niobium compounds and vanadium compounds are used as the above-mentioned superconductor materials. More specifically, Nb, Nb-Ti, Nb-Zr, NbN·TiN, NbN, NbC, Nb₃Sn, NbAl, Nb₃Ga, Nb₃Ge and V₃Ga are used. These materials belong to the category of the second class or type II superconductors and have the above-mentioned characteristics. In the actual practice, however, Nb-Ti is particularly suitable. Although high-purity aluminum or copper are particularly suitable as a metal layer to be laminated with the superconductor films, low-purity aluminum, copper or other metals can also be used.

The composite lamination of superconducting films and metal layers is made by forming a thin superconductor film on each metal layer using thin-film forming techniques such as sputtering, or by closely contacting a separately prepared superconductor film to each metal layer by ultrasonic soldering, or by simply laminating a film on each metal layer.

The thickness of the superconductor film must be not larger than the thickness obtained at the above-mentioned point of inflexion of the graph illustrating the above-mentioned relationship between the thickness of the superconductor film and the magnetic field shielding effect. If the film thickness exceeds the thickness obtained at the point of inflexion, the significant shielding effect of the present invention described later can hardly be achieved. The superconductor for a magnetic field shield according to the present invention can be obtained by using a single or a plurality of the above-mentioned composite laminations depending on the intensity of the magnetic field to be shielded. A plurality of the composition layers are made by alternately laminating the superconductor films on the metal layers.

The function and operation of a superconductor for a magnetic field shield according to the present invention are described below with reference to the drawings of the embodiments as explained before.

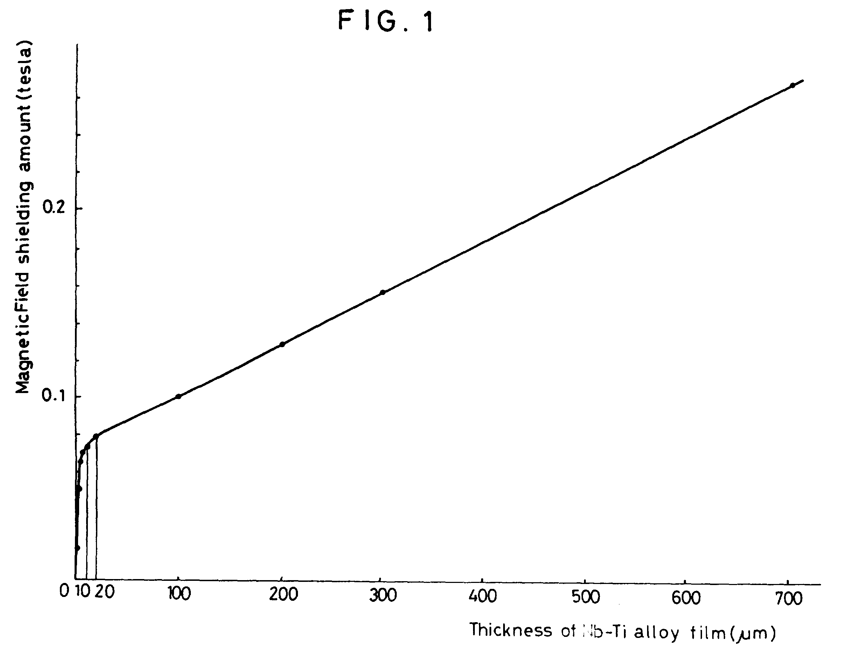

Fig. 1 shows a graph illustrating the relationship between the thickness of a Nb-Ti alloy film (Nb 50%, Ti 50% by weight) and the magnetic field shielding effect of the film. The axis of abscissas represents the thickness (unit: µm) of the Nb-Ti alloy film and the axis of ordinates represents the magnetic flux shielding value (unit: tesla) of the film, respectively. According to Fig. 1, the magnetic flux shielding value, i. e., magnetic flux shielding effect abruptly increases as the thickness of the Nb-Ti alloy film increases from nearly zero (the origin) to approximately 20 µm (mostly 10 µm), and beyond that point the shielding effect increases only gradually with a relatively small gradient if the thickness exceeds 20 µm.

In the prior art, when a magnetic field was shielded by a superconductor film of this type, a relatively thick superconductor film of 100 to 500 µm was conventionally used as described before, and it was understood that the thickness of the superconductor film was proportional to the magnetic flux shielding effect of the superconductor film.

Accordingly, the magnetic flux shielding effect of the superconductor film having a smaller thickness than 20 µm was estimated by calculation on the basis of measurement values obtained from a superconductor film having a thickness between 100 and 500 µm. However, once it had been found that the magnetic flux shielding effect of a superconductor film has a characteristic as shown in Fig. 1, it became clear that the magnetic flux shielding effect of a superconductor film having a thickness not larger than 20 µm is by far greater than a conventionally estimated value.

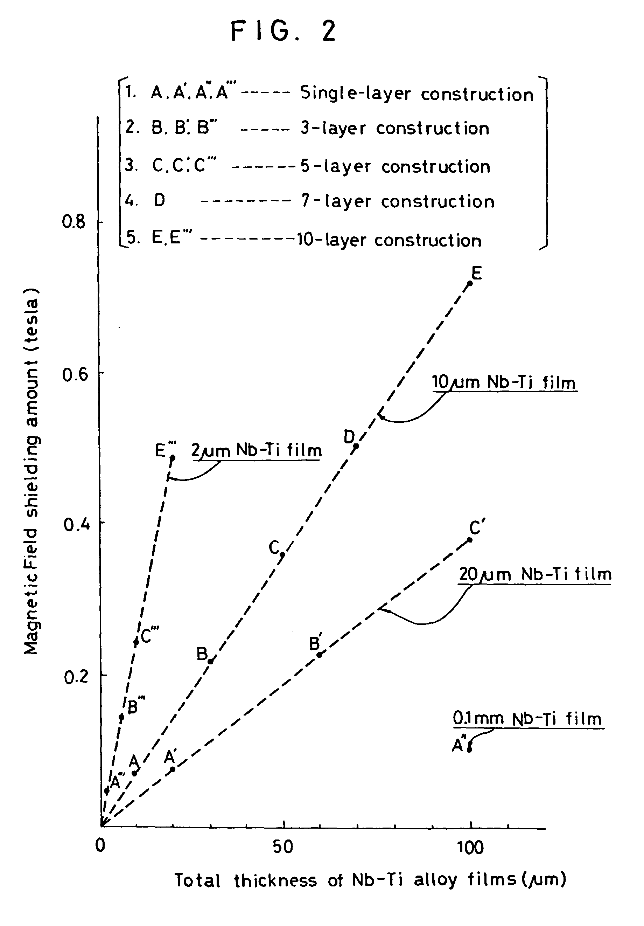

Therefore, even a thin superconductor film can be used as a superconductor for a magnetic field shield depending on the intensity of a magnetic field (terrestrial magnetic field for example). Furthermore, according to another experiment conducted by the inventors of the present invention, the magnetic field shielding effect of a multilayer structure of superconductor films, each of which has the same thickness, is proportional to the number of the layers as shown in Fig. 2.

Consequently, according to Fig. 1 it is clear that the magnetic field shielding effect of a multilayer structure of Nb-Ti films, each of which has a thickness not larger than 20 µm, is by far greater than that of the multilayer structure of Nb-Ti films, each of which has a thickness larger than 20 µm, provided that the total thickness is the same.

Table 1 - (1) and Table 1 - (2) show the relationship between the thickness of a single layer of the Nb-Ti alloy film and the magnetic field shielding effect depending on the number of layers, respectively. Table 1 - (1) deals with Nb-Ti alloy films each of which has a thickness between 10 and 100 µm, and Table 1 (2) deals with Nb-Ti alloy films each of which has a very small thickness between 1 and 5 µm.

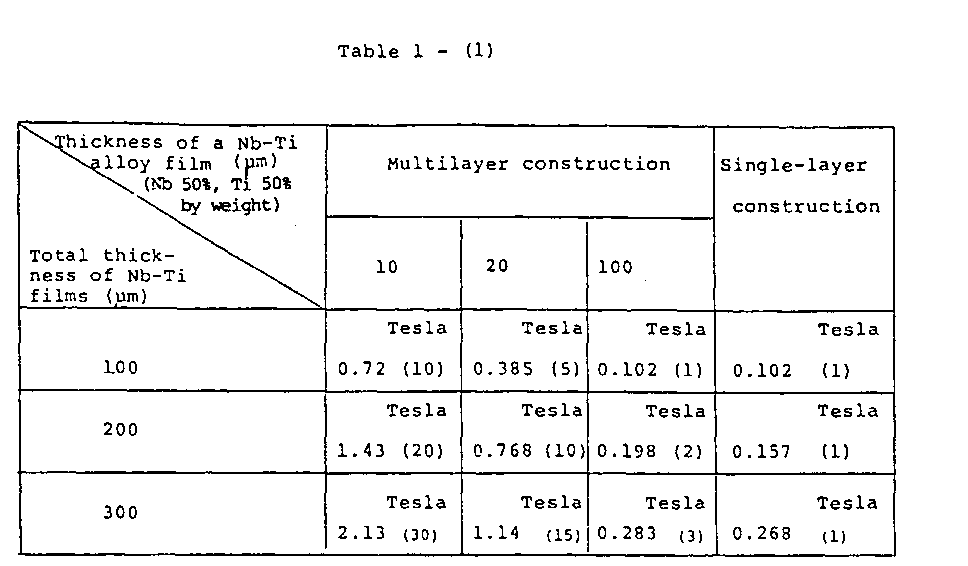

The values in parentheses represent the number of layers.

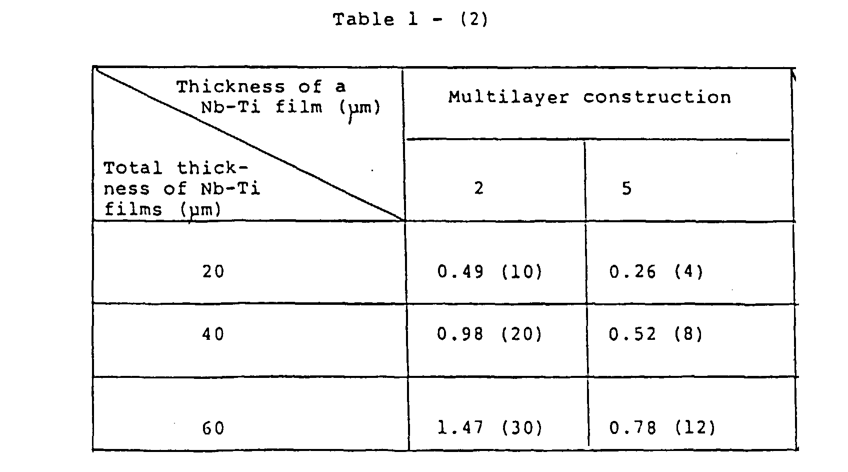

The values in parentheses represent the number of layers.

As obviously shown in Table 1 - (1), a greater magnetic field shielding effect is obtained by using superconductor films each of which has a smaller thickness, provided that the total thickness is the same. This is significant when the thickness is not larger than 20 µm (the thickness obtained at the point of inflexion). This phenomenon is based on the above-mentioned two facts found by the inventors of the present invention. A superconductor having this kind of characteristics is especially useful when used for shielding intense magnetic fields. Assume a superconductor for a magnetic field shield consisting of a multilayer structure of Nb-Ti alloy films having a total thickness of 300 µm as an example . In the case of a conventional superconductor, three layers of 100 µm films are necessary as shown in Table 1 - (1). Such a superconductor has a magnetic field shielding amounting to 0.283 tesla. In the case of the superconductor according to the present invention, 30 layers of 10 µm Nb-Ti films are used and a magnetic field shielding amounting to 2.13 tesla is obtained. As results from this comparison, the efficiency of the superconductor according to the present invention is 7.5 times higher than that of a conventional shield.

Table 1 - (2) deals with Nb-Ti alloy films each of which has a smaller thickness than the films dealt with in Table 1 - (1).

It is clear that in the case of films each of which has a thickness not larger than 10 µm the value of the magnetic field shielding increases significantly as the thickness of the film is smaller. More specifically, if 10 µm films are used to shield a magnetic flux density of approximately 1.4 tesla for example, a shielding having the total thickness of 200 µm is necessary (according to Table 1 - (1)). If 2 µm films are used, however, the total thickness can be reduced to 60 µm, approximately one third of the thickness required for a superconductor made of 10 µm films.

These results completely overthrow the conventionally accepted theory that thicker superconductor films should be used for shielding more intense magnetic fields. It goes without saying that these findings according to the present invention are a breakthrough in practice.

As shown in Tables 1 - (1) and 1 - (2), the characteristics of a superconductor film can be obtained most effectively when the thickness of its layer is very thin. However, if thinner layers are used, more layers of the films are necessary for shielding an intense magnetic flux density. This needs a higher number of production processes and increases production cost. Therefore, the thickness of a superconductor layer should preferably be between 2 to 10 µm in actual practice. The thickness of an Nb-Ti alloy film is 20 µm at the point of inflexion shown in Fig. 1. However, this thickness at the point of inflexion may vary depending on the filming or film producing speed or substrate temperature in the case of sputtering even when there is no difference in the composition of Nb-Ti alloy. The thickness at the point of inflexion may reach 80 µm in some cases. The superconductor for a magnetic field shield according to the present invention comprises a composite lamination of the above-mentioned superconductor film and metal layer made of aluminum or copper. The metal layer is used to stabilize (mainly cool) the superconductor film. More specifically, since the heat conductivity of the composite lamination is by far greater than that of the superconductor made of the superconductor film only, the metal layer can efficiently radiate or dissipate heat from the superconductor film and prevents a temperature increase due to flux flow. Furthermore, the metal layer forms a current circuit in the area where a transition to the normal region occurs to reduce heat generation, and has a braking effect to quick magnetic flux variation such as flux jumping.

When a multilayer structure of superconductor films is exposed to an intense magnetic field, the first layer closest to the magnetic field is affected most seriously by the magnetic field. The second layer and the subsequent layers are less affected. The last layer is not affected at all. This function is only possible when all the layers operate stably, for instance if a flux jumping occurs at the first layer, an abrupt magnetic field change occurs at the second layer, thus a second flux jumping also occurs at the second layer, resulting in that the desired magnetic field shielding effect cannot be obtained.

Since the superconductor for a magnetic field shield according to the present invention comprises a composite lamination of a thin superconductor film and a metal layer having the above-mentioned function, flux jumping is prevented and the superconductor layer is stabilized. Thus, the original characteristics of the superconductor layer can be fully utilized.

When a single metal layer is used, a ready-made sheet is applied. When a multilayer structure of the metal layers is used, it is advantageous and preferred to use thin films made by thin-film forming techniques such as sputtering or vacuum evaporation for the metal layers, except for the bottom metal layer sheet, to make the total thickness of the shield thinner as explained in detail hereinafter.

Embodiments according to the invention are described below.

### Example 1

(a) Preparation of composite laminations;
   (a-1) Nb-Ti alloy films were formed by sputtering on a commercially available aluminum foil (13 µm in thickness) to obtain six types of composite laminations comprising Nb-Ti alloy films having thicknesses of 0.95, 2.0, 4.5, 8.5, 12 and 20 µm.
   (a-2) Four types of Nb-Ti alloy films having thicknesses of 100, 200, 300 and 700 µm were prepared by rolling. Their surfaces were pickled and coated with a thin solder film by ultrasonic soldering. The surface of a 1.0 mm thick copper sheet was also coated with a thin solder film. Each type of Nb-Ti alloy film was laminated with the copper sheet, and pressed and heated to obtain four types of composite laminations. These were used for comparison.
(b) Measurement of the value of the magnetic field shielding; The above-mentioned composite laminations were formed in discs of 47 mm in diameter. The value of the magnetic field shielding was measured at the center of each disc. The measurement values are shown in Fig. 1. From Fig. 1 it is clear that the magnetic field shielding effect abruptly increases in the thickness range between nearly 0 and 20 µm (mostly 10 µm) and thereafter the increasing rate drops considerably. That is, the effect increases only gradually if the thickness exceeds 20 µm.
(c) Lamination of composite lamination;
   Three types of composite laminations comprising Nb-Ti alloy films having thicknesses of 2, 10 and 20 µm, each type of which was laminated in three to ten layers.
(d) Measurement of the value of the magnetic flux shielding; The values of the magnetic field shielding of the multilayer composite laminations prepared as described under item (c) and that of a single composite lamination were measured in the same way as described unter item (b). The measurement results are shown in Fig.2. From Fig. 2 it is clear that the magnetic field shielding effect is proportional to the number of composite laminations.

According to the results shown in Fig. 2, it can be inferred that the multilayer composite laminations comprising Nb-Ti alloy films, each of which has a thickness not larger than 20 µm, and copper sheets have a considerably greater magnetic field shielding effect than multilayer composite laminations comprising Nb-Ti alloy films, each of which has a larger thickness than 20 µm, and copper sheets even when the total thickness of the former is smaller than that of the latter. Since flux jumping is prevented by the stabilization action of the copper layer, the characteristics of Nb-Ti alloy films are assumed to be fully available.

### Example 2

(a) Preparation of composite laminations;
   NbN·TiN films were formed by sputtering Nb-Ti alloy on aluminum foil in an atmosphere of nitrogen (N₂) gas to obtain two types of composite laminations comprising NbN·TiN films having thicknesses of 2 and 10 µm.
(b) Measurement of the value of the magnetic flux shielding; The composite laminations were laminated and their values of magnetic field shielding were measured in the same way as in Example 1. The composite laminations having 1, 3 and 5 layers were measured. The measurement results are shown in Table 2.

According to Table 2, the value of the magnetic field shielding of composite laminations comprising NbN·TiN films is approximately three times higher than that of composite laminations comprising Nb-Ti alloy films. In the case of bulk (ready-made films other than the films formed by thin-film forming techniques), its upper critical magnetic flux density where the superconducting effect can be maintained would be a value slightly higher than 10 tesla at 4.2 K from the commonsense standpoint of the industry concerned. In the case of the NbN.TiN films, however, its upper critical magnetic flux density is assumed to be considerably higher than 10 tesla from the commonsense standpoint of the industry concerned. Therefore, it is quite understandable that the composite laminations comprising NbN·TiN films can effectively shield magnetic fields having very high flux density values.

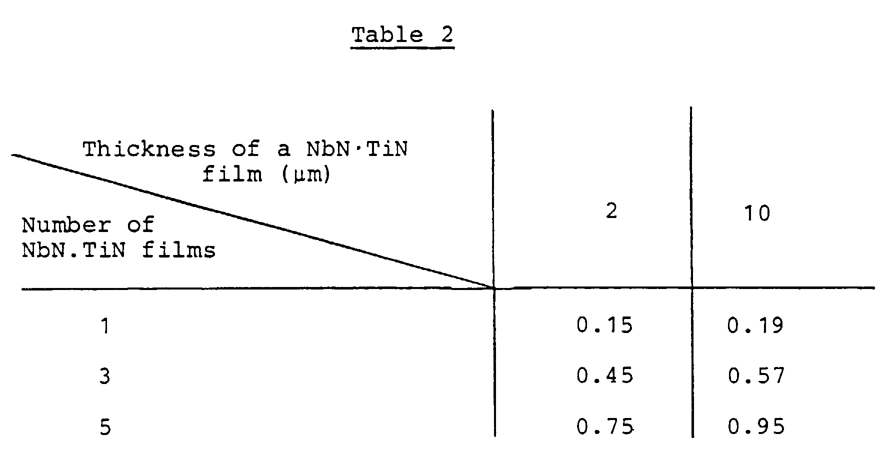

The composite laminations or laminated layers of the embodiments are used to repulse and concentrate magnetic force lines. This is the so-called "lens effect". By disposing the composite lamination(s) around the magnetic field the composite lamination(s) can shield the magnetic field on the one hand and can concentrate the magnetic force lines on the other hand so that a magnetic field having a high magnetic flux density can be taken out and used for other purposes.

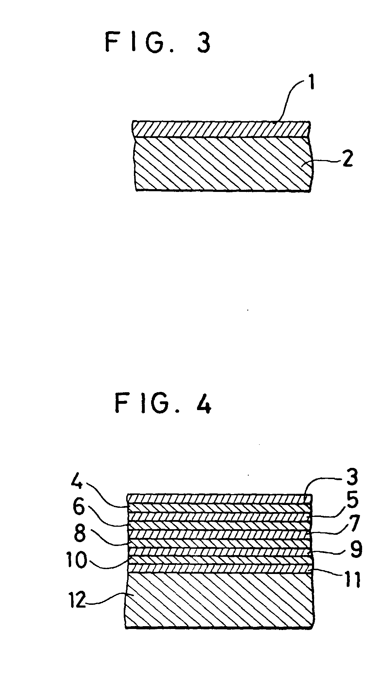

In the following,two constructions of a superconductor for a magnetic field shield according to the present invention are explained in detail below with reference to the drawings. Fig. 3 shows a single layer structure of a composite lamination, and Fig. 4 shows eight layers of composite laminations. Reference numeral 1 designates a thin film superconductor. Reference numeral 2 designates a ready-made metal sheet. In Fig. 4, a metal sheet 12 is placed at the bottom and forms a substrate. Metal layers 4, 6, 8 and 10 which are laminated alternately with the superconductor films on the metal sheet 12 are films formed by sputtering or vacuum evaporation. In this embodiment shown in Fig. 4, the metal films 4, 6, 8 and 10 are used for significantly reducing the total thickness of the multilayer construction. The metal sheet 12 placed at the bottom functions as a substrate. Reference numerals 3, 5, 7, 9 and 11 designate superconductor films formed by thin-film forming techniques. For example, the metal sheet 12 is a 13 µm thick ready-made aluminum sheet, the metal films 4, 6, 8 and 10 are 2 µm thick aluminum evaporation films and the superconductor films 3, 5, 7, 9 and 11 are 2 µm thick Nb-Ti alloy evaporation films.

As described above, the superconductor for a magnetic field shield according to the present invention provides for an effective combination of the above-mentioned magnetic field shielding characteristics which have not been known and for a stabilizing action of the metal layers. Thus, the superconductor for a magnetic field shield according to the present invention ensures a high magnetic field shielding effect even when the shield comprises thin layers. If applied to various magnetic field shielding devices, it is obvious that the superconductor according to the present invention can be effectively used to reduce the weight and the costs for such devices. Furthermore, the superconductor according to the present invention can be formed or fabricated more easily since it is made of thin films.

No doubt, the superconductor according to the present invention will be highly useful for evaluation in many fields as a superconductor for magnetic field shields having a very high practical use.

## Claims

1. A magnetic field shield, including a plurality of composite laminations of a metal layer (2) which efficiently radiates or dissipates heat, and a superconductor film (1) made of a type II superconductor,
characterized in that the thickness of each superconductor film (1; 3, 5, 7, 9, 11) is in the range of 2 to 20 µm,
in that the thickness of each superconductor film (1; 3, 5, 7, 9, 11) is determined from the point of inflexion of a graph representing the relationship between the magnetic shielding effect and the thickness of a single superconductor film (1; 3, 5, 7, 9, 11),
and in that the thickness of each superconductor film (1; 3, 5, 7, 9, 11) is not more than that obtained at the point of inflexion of the graph.

2. A magnetic field shield, including a plurality of composite laminations of a metal layer (2) which efficiently radiates or dissipates heat, and a superconductor film (1) made of a type II superconductor,
characterized in that the type II superconductor material is Nb-Ti,
in that the thickness of each superconductor film (1; 3, 5, 7, 9, 11) is in the range of 0.95 to 20 µm,
in that the thickness of each superconductor film (1; 3, 5, 7, 9, 11) is determined from the point of inflexion of a graph representing the relationship between the magnetic shielding effect and the thickness of a single superconductor film (1; 3, 5, 7, 9, 11),
and in that the thickness of each superconductor film (1; 3, 5, 7, 9, 11) is not more than that obtained at the point of inflexion of the graph, which is 20 µm in the case of Nb-Ti.

3. The shield according to claim 1,
wherein the superconductor material is selected from the group of niobium, niobium alloys, niobium compounds or vanadium compounds, in particular Nb, Nb-Zr, NbN·TiN, NbN, NbC, Nb₃Sn, Nb₃Al, Nb₃Ga, Nb₃Ge and/or V₃Ga.

4. The shield according to claim 1,
wherein the superconductor film (1; 3, 5, 7, 9, 11) is made of an NbN·TiN compound and the metal layer (2; 4, 6, 8, 10, 12) is made of high-purity aluminum or copper.

5. The shield according to claim 2,
wherein the superconductor film (1; 3, 5, 7, 9, 11) is made of an Nb-Ti alloy and the metal layer (2; 4, 6, 8, 10, 12) is made of high-purity aluminum or copper.

6. The shield according to any of claims 1 to 5,
wherein the superconductor film (1; 3, 5, 7, 9, 11) is formed on the metal layer (2; 4, 6, 8, 10, 12) by thin-film forming techniques such as sputtering.

7. The shield according to any of claims 1 to 5,
wherein the superconductor film (1; 3, 5, 7, 9, 11) is closely contacted with the metal layer (2; 4, 6, 8, 10, 12) by ultrasonic soldering or is laminated with the metal layer (2; 4, 6, 8, 10, 12) without adhering means.

8. The shield according to any of claims 1 to 7,
wherein the metal layer (2; 4, 6, 8, 10, 12) is a sheet metal made of aluminum or copper, in particular a thin aluminum film or a thin copper film made by thin-film forming techniques.

9. The shield according to any of claims 1 to 8,
wherein the plurality of the composite laminations consists of thin superconductor layers (11, 9, 7, 5, 3) which are alternately laminated on a metal sheet (12) and further metal films (10, 8, 6, 4), respectively.

10. The shield according to any of claims 1 to 9,
wherein the thickness of each superconductor film (1; 3, 5, 7, 9, 11) is in the range of 2 to 10 µm.

11. A process for producing a magnetic field shield, comprising the following steps:
- determining the point of inflexion on a graph of the relationship between the magnetic shielding effect and the thickness of a single superconductor film (1) of a type II superconductor material;
- selecting a thickness of the superconductor film (1) in the range of 2 to 20 µm, wherein the thickness is no more than the thickness value at the point of inflexion;
- forming a plurality of composite laminations, each comprising the superconductor layer (3, 5, 7, 9, 11) formed on a metal layer (2, 4, 6, 8, 10, 12).

12. A process for producing a magnetic field shield, comprising the following steps:
- determining the point of inflexion on a graph of the relationship between the magnetic shielding effect and the thickness of a single superconductor film (1) of the type II superconductor material Nb-Ti;
- selecting a thickness of the superconductor film in the range of 0.95 to 20 µm, wherein the latter value is the thickness value at the point of inflexion;
- forming a plurality of composite laminations, each comprising the superconductor layer (3, 5, 7, 9, 11) formed on a metal layer (2, 4, 6, 8, 10, 12).

## Patentansprüche

1. Magnetfeldabschirmung, die eine Vielzahl von zusammengesetzten Laminierungen aus einer Metallschicht (2), die in wirksamer Weise Wärme abstrahlt oder abgibt, und einer supraleitenden Schicht (1) aus einem Supraleiter vom Typ II aufweist,
dadurch gekennzeichnet,
daß die Dicke von jeder supraleitenden Schicht (1; 3, 5, 7, 9, 11) im Bereich von 2 bis 20 µm liegt,
daß die Dicke von jeder supraleitenden Schicht (1; 3, 5, 7, 9, 11) aus dem Knickpunkt eines Graphen bestimmt wird, der den Zusammenhang zwischen der magnetischen Abschirmungswirkung und der Dicke einer einzelnen supraleitenden Schicht (1; 3, 5, 7, 9, 11) repräsentiert,
und daß die Dicke von jeder supraleitenden Schicht (1; 3, 5, 7, 9, 11) nicht größer ist als diejenige, die am Knickpunkt des Graphen erhalten wird.

2. Magnetische Abschirmung, die eine Vielzahl von zusammengesetzten Laminierungen aus einer Metallschicht (2), die in wirksamer Weise Wärme abstrahlt oder abgibt, und einer supraleitenden Schicht (1) aus einem Supraleiter vom Typ II aufweist,
dadurch gekennzeichnet,
daß das supraleitende Material vom Typ II Nb-Ti ist,
daß die Dicke jeder supraleitenden Schicht (1; 3, 5, 7, 9, 11) im Bereich von 0,95 bis 20 µm liegt,
daß die Dicke jeder supraleitenden Schicht (1; 3, 5, 7, 9, 11) aus dem Knickpunkt des Graphen bestimmt wird, der den Zusammenhang zwischen der magnetischen Abschirmungswirkung und der Dicke einer einzelnen supraleitenden Schicht (1; 3, 5, 7, 9, 11) repräsentiert,
und daß die Dicke jeder supraleitenden Schicht (1; 3, 5, 7, 9, 11) nicht größer ist als diejenige, die an dem Knickpunkt des Graphen erhalten wird, welche im Falle von Nb-Ti 20 µm beträgt.

3. Abschirmung nach Anspruch 1,
wobei das supraleitende Material aus der Gruppe von Niob, Niob-Legierungen, Niob-Verbindungen oder Vanadium-Verbindungen gewählt ist, insbesondere aus Nb, Nb-Zr, NbN·TiN, NbN, NbC, Nb₃Sn, Nb₃Al, Nb₃Ga, Nb₃Ge und/oder V₃Ga.

4. Abschirmung nach Anspruch 1,
wobei die supraleitende Schicht (1; 3, 5, 7, 9, 11) aus einer Nb·TiN-Zusammensetzung besteht und die Metallschicht (2; 4, 6, 8, 10, 12) aus hochreinem Aluminium oder Kupfer besteht.

5. Abschirmung nach Anspruch 2,
wobei die supraleitende Schicht (1; 3, 5, 7, 9, 11) aus einer Nb-Ti-Legierung besteht und die Metallschicht (2; 4, 6, 8, 10, 12) aus hochreinem Aluminium oder Kupfer besteht.

6. Abschirmung nach einem der Ansprüche 1 bis 5,
wobei die supraleitende Schicht (1; 3, 5, 7, 9, 11) auf der Metallschicht (2; 4, 6, 8, 10, 12) mit einer Dünnschicht-Herstellungstechnik, beispielsweise durch Sputtern, gebildet ist.

7. Abschirmung nach einem der Ansprüche 1 bis 5,
wobei die supraleitende Schicht (1; 3, 5, 7, 9, 11) in engem Kontakt mit der Metallschicht (2; 4, 6, 8, 10, 12) steht, und zwar durch Ultraschallschweißen oder ohne Klebemittel auf die Metallschicht (2; 4, 6, 8, 10, 12) laminiert ist.

8. Abschirmung nach einem der Ansprüche 1 bis 7,
wobei die Metallschicht (2; 4, 6, 8, 10, 12) ein Metall-flächenkörper aus Aluminium oder Kupfer ist, insbesondere eine dünne Aluminiumschicht oder eine dünne Kupferschicht, die durch eine Dünnschicht-Herstellungstechnik ausgebildet ist.

9. Abschirmung nach einem der Ansprüche 1 bis 8,
wobei die Vielzahl von zusammengesetzten Laminierungen aus dünnen supraleitenden Schichten (11, 9, 7, 5, 3,) besteht, die abwechselnd auf einen Metall-Flächenkörper (12) bzw. weitere Metallschichten (10, 8, 6, 4,) laminiert sind.

10. Abschirmung nach einem der Ansprüche 1 bis 9,
wobei die Dicke von jeder supraleitenden Schicht (1; 3, 5, 7, 9, 11) im Bereich von 2 bis 10 µm liegt.

11. Verfahren zur Herstellung einer Magnetfeldabschirmung, das folgende Schritte aufweist:
- Bestimmen des Knickpunktes auf einem Graphen des Zusammenhanges zwischen der magnetischen Abschirmungswirkung und der Dicke einer einzelnen supraleitenden Schicht (1) eines supraleitenden Materials vom Typ II;
- Wählen der Dicke der supraleitenden Schicht (1) in dem Bereich von 2 bis 20 µm, wobei die Dicke nicht größer ist als der Dickenwert an dem Knickpunkt; und
- Herstellen einer Vielzahl von zusammengesetzten Laminierungen, die jeweils die supraleitende Schicht (3, 5, 7, 9, 11) aufweisen, die auf einer Metallschicht (2, 4, 6, 8, 10, 12) ausgebildet ist.

12. Verfahren zur Herstellung einer Magnetfeldabschirmung, das folgende Schritte aufweist:
- Bestimmen des Knickpunktes eines Graphen des Zusammenhanges zwischen der magnetischen Abschirmungswirkung und der Dicke einer einzelnen supraleitenden Schicht (1) des supraleitenden Materials Nb-Ti vom Typ II;
- Wählen der Dicke der supraleitenden Schicht in dem Bereich von 0,95 bis 20 µm, wobei der zuletzt genannte Wert der Dickenwert an dem Knickpunkt ist; und
- Herstellen einer Vielzahl von zusammengesetzten Laminierungen, die jeweils die supraleitende Schicht (3, 5, 7, 9, 11) aufweisen, die auf einer Metallschicht (2, 4, 6, 8, 19, 12) ausgebildet ist.

## Revendications

1. Blindage de protection contre un champ magnétique, comprenant une pluralité de feuilles composites d'une couche métallique (2), qui rayonne ou dissipe efficacement la chaleur, et un film supraconducteur (1) formé d'un supraconducteur de type II,
caractérisé en ce que l'épaisseur de chaque film supraconducteur (1;3,5,7,9,11) se situe dans la gamme de 2 à 20 µm,
que l'épaisseur de chaque film supraconducteur (1;3,5,7, 9, 11) est déterminée à partir du point d'inflexion d'une courbe représentant la relation entre l'effet de blindage magnétique et l'épaisseur d'un seul film supraconducteur (1; 3,5,7,9,11), et
en ce que l'épaisseur de chaque film supraconducteur (1; 3,5,7,9,11) n'est pas supérieure à celle obtenue au niveau du point d'inflexion de la courbe.

2. Blindage de protection vis-à-vis d'un champ magnétique, comprenant une pluralité de feuilles composites d'une couche métallique (2), qui rayonne ou dissipe efficacement la chaleur, et un film supraconducteur (1) formé d'un supraconducteur de type II,
caractérisé en ce que le matériau supraconducteur de type II est du Nb-Ti,
en ce que l'épaisseur de chaque film supraconducteur (1; 3,5,7,9,11) se situe dans la gamme de 0,95 à 20 µm,
en ce que l'épaisseur de chaque film supraconducteur (1; 3,5,7,9,11) est déterminée à partir du point d'inflexion d'une courbe représentant la relation entre l'effet de blindage magnétique et l'épaisseur d'un seul film supraconducteur (1; 3,5,7,9,11), et
en ce que l'épaisseur de chaque film supraconducteur (1; 3,5,7,9,11) n'est pas supérieure à celle obtenue au niveau du point d'inflexion de la courbe, qui est égale à 20 µm dans le cas du Nb-Ti.

3. Blindage selon la revendication 1,
dans lequel le matériau supraconducteur est choisi dans le groupe comprenant le niobium, les alliages de niobium, les composés du niobium ou les composés de vanadium, en particulier Nb, Nb-Zr, NbN.TiN, NbN, NbC, Nb₃Sn, Nb₃Al, Nb₃Ga, Nb₃Ge et/ou V₃Ga.

4. Blindage selon la revendication 1,
dans lequel le film supraconducteur (1; 3,5,7,9,11) est formé d'un composé NbN.TiN et la couche métallique (2;4,6, 8,10,12) est formée d'aluminium ou de cuivre de grande pureté.

5. Blindage selon la revendication 2,
dans lequel le film supraconducteur (1; 3,5,7,9,11) est formé d'un alliage de Nb-Ti et la couche métallique (2;4, 6,8,10,12) est formée d'aluminium ou de cuivre de grande pureté.

6. Blindage selon l'une quelconque des revendications 1 à 5, dans lequel le film supraconducteur (1; 3,5,7,9,11) est formé sur la couche métallique (2;4,6, 8,10,12) au moyen de techniques de formation de couches minces, comme par exemple par pulvérisation.

7. Blindage selon l'une quelconque des revendications 1 à 5,
dans lequel le film supraconducteur (1; 3,5,7,9,11) est placé en contact intime avec la couche métallique (2;4,6,8,10,12) par soudage par ultrasons ou est superposé à la couche métallique (2;4,6,8,10,12) sans aucun agent adhésif.

8. Blindage selon l'une quelconque des revendications 1 à 7,
dans lequel la couche métallique (2;4,6,8,10,12) est une feuille formée d'un métal tel que l'aluminium ou le cuivre, en particulier un film mince d'aluminium ou un film mince de cuivre formé par des techniques de formation de couches minces.

9. Blindage selon l'une quelconque des revendications 1 à 8,
dans lequel la pluralité de feuilles composites constituent des couches minces supraconductrices (11,9,7,5,3), qui sont superposées de façon alternée sur une feuille métallique (12) et d'autres films métalliques (10,8,6,4) respectivement.

10. Blindage selon l'une quelconque des revendications 1 à 9,
dans lequel l'épaisseur de chaque film supraconducteur (1; 3,5,7,9,11) se situe dans la gamme de 2 à 10 µm.

11. Procédé pour fabriquer un blindage de protection vis-à-vis d'un champ magnétique, comprenant les étapes suivantes :
- détermination du point d'inflexion d'une courbe représentant la relation entre l'effet de blindage magnétique et l'épaisseur d'un seul film supraconducteur (1) formé d'un matériau supraconducteur de type II;
- sélection d'une épaisseur du film supraconducteur (1) dans la gamme de 2 à 20 µm, l'épaisseur n'étant pas supérieure à la valeur de l'épaisseur au niveau du point d'inflexion;
- formation d'une pluralité de stratifiés composites comprenant chacun la couche supraconductrice (3;5,7,9,11) formée sur une couche métallique (2,4,6,8,10,12).

12. Procédé pour fabriquer un blindage de protection vis-à-vis d'un champ magnétique, comprenant les étapes suivantes :
- détermination du point d'inflexion d'une courbe représentant la relation entre l'effet de blindage magnétique et l'épaisseur du film supraconducteur unique (1) formé du matériau supraconducteur de type II Nb-Ti;
- choix d'une épaisseur du film supraconducteur dans la gamme de 0,95 à 20 µm, cette dernière valeur étant la valeur de l'épaisseur au niveau du point d'inflexion;
- formation d'une pluralité de stratifiés composites comprenant chacun la couche supraconductrice (3,5,7,9,11) formée sur une couche métallique (2,4,6,8,10,12).
